# EUROPÄISCHE PATENTSCHRIFT

(11) **EP 0 515 815 B1**
(45) Veröffentlichungstag und Bekanntmachung des Hinweises auf die Patenterteilung: **30.07.1997**
(21) Anmeldenummer: 92106392.1
(22) Anmeldetag: 14.04.1992
(51) Int. Cl.: H01L 29/06, H01L 29/73

(54) **Halbleiteranordnung mit p-n-Übergang und zugeordneter Elektrodenanordnung**
Semi-conductor device with PN junction and electrode arrangement
Dispositif semi-conducteur à jonction PN et arrangement d'électrodes

(30) Priorität: 31.05.1991 DE 4117959
(43) Veröffentlichungstag der Anmeldung: 02.12.1992
(73) Patentinhaber: ROBERT BOSCH GMBH, 70442 Stuttgart (DE)
(72) Erfinder: Goerlach, Alfred, W-7408 Kusterdingen (DE); Denner, Volkmar, Dr., W-7417 Pfullingen (DE)
(74) Vertreter: Friedmann, Jürgen, Dr.-Ing.

(56) Entgegenhaltungen:
- EP-A- 0 485 648
- WO-A-83/02528
- WO-A-83/02529
- GB-A- 2 077 493
- US-A- 4 713 681
- PATENT ABSTRACTS OF JAPAN vol. 14, no. 82 (E-889)(4025) 14. Februar 1990 & JP-A-12 95 465
- PATENT ABSTRACTS OF JAPAN vol. 9, no. 10 (E-290)17. Januar 1985 & JP-A-59 161 066

## Beschreibung

### Stand der Technik

Die Erfindung betrifft eine Halbleiteranordnung mit einem p-n-Übergang, dem im Bereich der zugehörigen Raumladungszone eine Elektrodenanordnung zur Beeinflussung der Durchbruchspannung zugeordnet ist, wobei die Elektrodenanordnung eine Elektrode und eine der Elektrode zugeordnete Isolationsschicht aufweist.

Aus den europäischen Patentschriften 98 834 und 99 897 sind Halbleiteranordnungen der vorstehend genannten Art bekannt. Über der Raumladungszone eines p-n-Übergangs der Halbleiteranordnung ist eine mittels Isolationsschicht abgetrennte Elektrode angeordnet, die mit einem bestimmten Potential relativ zum p-Leiter und/oder n-Leiter des p-n-Übergangs vorgespannt werden kann. Hierdurch läßt sich die Durchbruchspannung des p-n-Übergangs beeinflussen.

Aus der europäischen Patentanmeldung 485 648 ist bereits ein Halbleiterbauelement bekannt, bei dem in ein n-dotiertes Substrat eine stark dotierte p-Zone und ein stark dotierte n-Zone eingebracht sind. Weiterhin ist eine Elektrode vorgesehen, die durch eine Isolationsschicht von der Oberfläche des Halbleitersubstrats isoliert ist. Die Elektrode wird mit dem gleichen Potential beaufschlagt wie die p-Dotierung. Diese Druckschrift gehört zum Stand der Technik im Sinn des Artikels 54(3) EPÜ.

### Vorteile der Erfindung

Die erfindungsgemäße Halbleiteranordnung mit den im Hauptanspruch genannten Merkmalen hat demgegenüber den Vorteil, daß eine Vergrößerung der Durchbruchspannung erzielt wird. Hierzu weist die Isolationsschicht an ihrem dem p-Leiter des p-n-Übergangs zugeordneten Bereich eine andere Dicke als in ihrem dem zugehörigen n-Leiter zugeordneten Bereich auf. Welcher der beiden Bereiche, nämlich der dem p-Leiter zugeordnete Bereich oder der dem n-Leiter zugeordnete Bereich die größere Dicke besitzt, hängt von dem individuellen Aufbau ab und läßt sich vom Fachmann entsprechend wählen.

Die Isolationsschicht ist vorzugsweise von einer Oxidschicht gebildet. Die Elektrode kann von einer Metallschicht gebildet sein, an der die Oxidschicht ausgebildet ist.

Der erwähnte p-n-Übergang kann an unterschiedlichsten Halbleiter-Bauteilen ausgebildet sein. Bevorzugt befindet er sich an einem Transistor, insbesondere an einem Transistor einer Darlington-Schaltung.

Die Ausgestaltung sieht vorzugsweise vor, daß dem p-n-Übergang ein an eine Gesamtspannung angeschlossener Spannungsteiler mit einem ersten Widerstand und einem zweiten Widerstand zugeordnet ist, wobei an dem ersten Widerstand eine erste Spannung und an dem zweiten Widerstand eine zweite Spannung abfällt, der Mittelanschluß des Spannungsteilers an der Elektrode angeschlossen ist und die beiden übrigen Anschlüsse des Spannungsteilers mit den Leitern des p-n-Übergangs in Verbindung stehen, indem der eine Anschluß mit dem p-Leiter und der andere Anschluß mit dem n-Leiter verbunden ist und daß dem einen Widerstand eine Verarmungsdurchbruchspannung und dem anderen Widerstand eine Anreichungsdurchbruchspannung zugeordnet ist. Bei diesen beiden Durchbruchspannungen handelt es sich bei einem Durchbruch um die an den zugehörigen Widerständen abfallenden Spannungen. Die Dicken der Isolationsschicht werden derart gewählt, daß die Anreicherungsdurchbruchspannung bei unveränderter erster Spannung beziehungsweise die Verarmungsdurchbruchspannung bei unveränderte zweiter Spannung im Vergleich zu einer gleichmäßig dicken Isolationsschicht erhöht wird. Hierdurch kommt es zu einer Vergrößerung der Gesamtspannung, da diese sich aus der Summe der ersten und der zweiten Spannung zusammensetzt. Je nach individuellem Aufbau ist entweder die Dicke der Isolationsschicht in dem dem p-Leiter zugeordneten Bereich größer oder kleiner als die Dicke in dem dem n-Leiter zugeordneten Bereich.

### Zeichnung

Die Erfindung wird im folgenden anhand der Figuren näher erläutert. Es zeigen:
- Figur 1: eine schematische Ansicht einer Halbleiteranordnung,
- Figur 2: eine Detailansicht der Raumladungszone der Halbleiteranordnung der Figur 1,
- Figur 3: eine der Figur 2 entsprechende Darstellung eines weiteren Ausführungsbeispiels der Erfindung und
- Figur 4: eine Draufsicht auf eine Halbleiteranordnung.

### Beschreibung von Ausführungsbeispielen

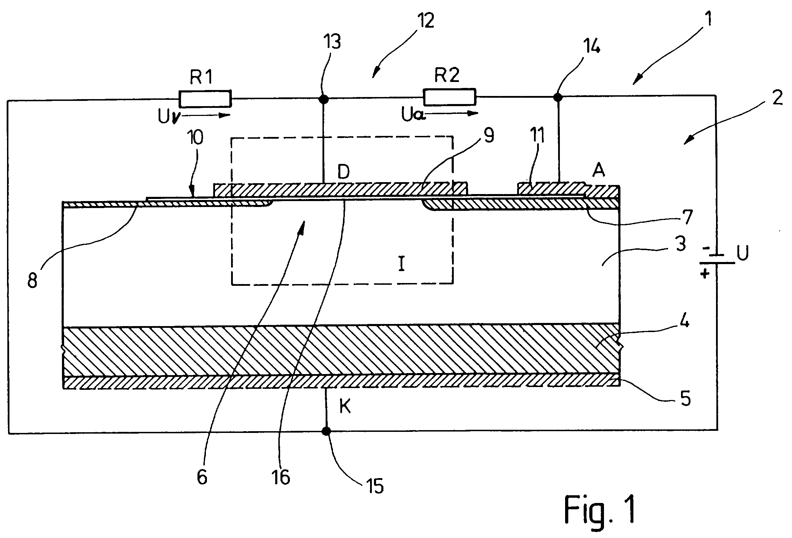

Die Figur 1 zeigt eine Halbleiteranordnung 1, die an einem bipolaren Transistor 2 ausgebildet ist. Die Halbleiteranordnung 1 kann mittels Planartechnik hergestellt sein.

Das Ausgangsmaterial für die Herstellung ist Silizium, das einen schwach n⁻ dotierten Bereich 3 aufweist, der an einen hoch n⁺ dotierten Bereich 4 angrenzt. Der Bereich 4 ist mit einer Metallschicht 5 kontaktiert; sie ist mit K bezeichnet und stellt bei dem Transistor 2 den Kollektor dar.

Die Halbleiteranordnung 1 weist ferner einen p-n-Übergang 6 auf, der einen p dotierten Leiter (p-Leiter 7), einen n⁻-Leiter (n-Leiter 3) und einen n⁺-Leiter (n-Leiter 8) besitzt. Der p-n-Übergang 6 kann in bekannter Weise mittels Fototechnik, Dotierung und Diffusion hergestellt sein. Der p-Leiter dient bei dem bipolaren Transistor 2 als Basis; er ist mit A bezeichnet. Der Übersichtlichkeit halber ist die bei dem bipolaren Transistor 2 in die Basiszone eingebrachte n⁺ dotierte Emitterzone nicht dargestellt. Der bereits erwähnte n-Leiter 8 kann gleichzeitig mit der Emitterdotierung eindiffundiert werden.

Im Bereich I des p-n-Übergangs 6, der von der in Figur 1 eingezeichneten Strichlinie berandet ist, befindet sich die sogenannte Raumladungszone.

Im Gebiet des p-n-Übergangs 6, und zwar im Bereich der Raumladungszone, befindet sich eine Elektrodenanordnung D, die eine Elektrode 9 aufweist, welche vom p-Leiter 7 und n-Leiter 8 und 3 aufgrund einer Isolationsschicht 10 galvanisch getrennt ist.

Die Figur 1 zeigt, daß der p-Leiter 7 durch den Bereich 3 vom n-Leiter 8 beabstandet liegt. Der so gebildete p-n-Übergang 6 ist von der Isolationsschicht 10 derart abgedeckt, daß sich die Isolationsschicht 10 teilweise auf dem n-Leiter 8 befindet, und zwar auf dem der Raumladungszone zugekehrten Bereich des n-Leiters, über den zwischen dem n-Leiter 8 und den p-Leiter 7 gelegenen Abschnitt des Bereichs 3 verläuft und ferner auf dem p-Leiter 7 angeordnet ist und zwar auf dem Abschnitt des p-Leiters 7, der der Raumladungszone 1 zugekehrt ist. Die Elektrode 9 weist eine geringere Ausdehnung als die Isolationsschicht 10 auf, wobei sie jedoch innerhalb der gesamten Raumladungszone liegt und Bereiche des n-Leiters 8 sowie des p-Leiters 7 überlappt.

Der die Basis des Transistors 2 bildende p-Leiter 7 ist mit einer Basismetallisierung 11 versehen. Der n-Leiter 8 steht elektrisch leitend mit dem Bereich 4 in Verbindung.

Zwischen Basis A und Kollektor K ist eine Gesamtspannung U (in Sperrichtung) angelegt, es liegt also eine Sperrspannung an. Ferner ist ein Spannungsteiler 12 vorgesehen, der einen ersten Widerstand R1 und einen zweiten Widerstand R2 aufweist, wobei der Mittelanschluß 13 des Spannungsteilers 12 an die Elektrode 9 angeschlossen ist, der dem Widerstand R2 zugeordnete Anschluß 14 an den Minus-Pol der Gesamtspannung U und an der Basis A liegt und der dem Widerstand R1 zugeordnete Anschluß 15 des Spannungsteilers 12 mit dem Kollektor K sowie dem positiven Pol der Gesamtspannng U verbunden ist. Die Widerstände R1 und R2 können als separate Bauteile ausgebildet sein oder sie sind monolithisch in die Halbleiteranordnung integriert.

An den Widerständen R1 beziehungsweise R2 fällt eine erste Spannung U1 beziehungsweise eine zweite Spannung U2 ab. Setzt man den ersten Widerstand R1 beziehungsweise den zweiten Widerstand R2 gleich Null, so ergeben sich die zwischen der Basis A und dem Kollektor K erreichbaren Durchbruchspannungen, Ua beziehungsweise Uv. Dabei ist die zweite Spannung Ua die Anreicherungsdurchbruchspannung und die erste Spannung Uv die Verarmungsdurchbruchspannung der Halbleiteranordnung 1.

Die Isolationsschicht 10 ist vorzugsweise von einem Oxid 16 gebildet. Die Elektrode 9, die als Deckelektrode bezeichnet wird, ist mittels des Oxids 16 von dem Bereich 3, dem p-Leiter 7 und dem n-Leiter 8 galvanisch getrennt.

Die maximal erreichbare Durchbruchspannung ist die Gesamtspannung U, die sich aus der Summe der ersten Spannung Uv und der zweiten Spannung Ua zusammensetzt, wenn die Beziehung gilt:
R1 : R2 = Uv : Ua

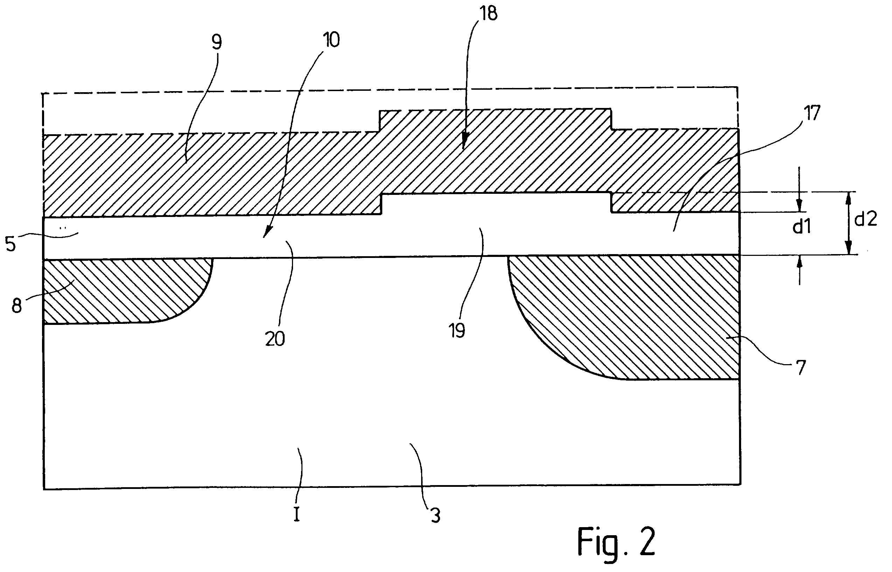

Erfindungsgemäß ist nun vorgesehen, daß die maximal erreichbare Durchbruchspannung (Gesamtspannung U) erhöht wird, indem man die Anreicherungsdurchbruchspannung Ua bei unveränderter erster Spannung Uv beziehungsweise die Verarmungsdurchbruchspannung Uv, bei unveränderter zweiter Spannung Ua, erhöht. Hierzu ist eine unterschiedliche Dicke d1 beziehungsweise d2 der Isolationsschicht 10 im Bereich I der Raumladungszone vorgesehen. Dies geht aus der Übersichtsdarstellung der Figur 1 nicht hervor, wird jedoch deutlich in Figur 2 gezeigt. Mithin handelt es sich um eine "gestufte" Oxidschicht (Oxid 16).

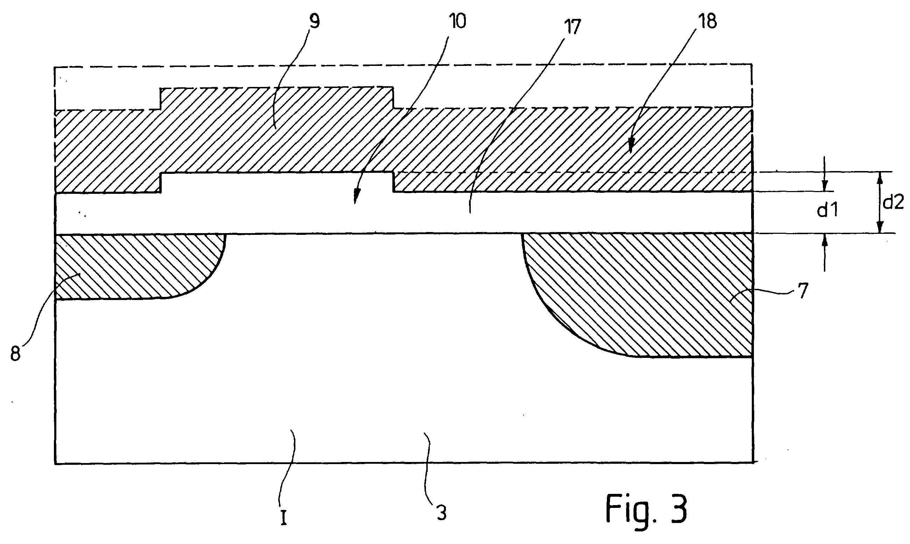

Die Figuren 2 bis 4 zeigen die Erfindung anhand eines mit integriertem Spannungsteiler 12 versehenen, planaren npn-Darlington-Transistor (Transistor 2). In den Figuren 2 und 3 ist lediglich die Raumladungszone im Bereich I aus Figur 1 nach zwei verschiedenen Ausführungsbeispielen dargestellt. Zunächst sei auf die Ausgestaltung der Figur 2 eingegangen.

In den Bereich 3 (Substrat) sind der n⁺ dotierte n-Leiter 8 und der p dotierte p-Leiter 7 durch entsprechende Herstellungsschritte eindiffundiert worden. Oberhalb des n-Leiters 8, des Bereichs 3 und des p-Leiters 7 befindet sich die Isolationsschicht 10, die als Oxidschicht 17 ausgebildet ist. Die Oxidschicht 17 ist mit einer Metallschicht 18 abgedeckt, die die Elektrode 9 bildet. Über dem n-Leiter 8 beziehungsweise dem p-Leiter 7 ist die Dicke der Isolationsschicht 10 beliebig, sie kann insbesondere auch dünner als im übrigen Bereich ausgebildet sein, da dies keinen Einfluß auf die Verarmungsdurchbruchspannung Uv beziehungsweise die Anreichungsdurchbruchspannung Ua hat. Die Größe der Verarmungsdurchbruchspannung Uv und auch die Größe der Anreicherungsdurchbruchspannung Ua wird erfindungsgemäß durch die Dicke der Oxidschicht 17 im übrigen Bereich der Raumladungszone I bestimmt.

Die Oxidschicht 17 weist zwei unterschiedliche Dicken, nämlich die Dicke d1 und die gegenüber der Dicke d1 größere Dicke d2 auf.

In der Figur 2 ist die Anordnung derart getroffen, daß die Oxidschicht 17 in ihrem dem p-Leiter 7 zugeordneten Bereich 19 die Dicke d2 und in ihrem dem n-Leiter 8 zugeordneten Bereich 20 die Dicke d1 aufweist. Damit ist für die Verarmungsdurchbruchspannung Uv die Dicke d1 über dem dem n-Leiter 8 benachbarten Bereich 3 (Kollektorgebiet) und für die Anreicherungsdurchbruchspannung Ua die Dicke d2 über dem dem p-Leiter 7 benachbarten Bereich 3 (Kollektorgebiet) verantwortlich. Hierdurch erhöht sich gegenüber der bekannten Anordnung, bei der eine Isolationsschicht mit gleicher Dicke vorgesehen ist, die Anreicherungsdurchbruchspannung Ua, wodurch die maximal erreichbare Durchbruchspannung (Gesamtspannung = Uv + Ua) bei gleicher Verarmungsdurchbruchspannung Uv erhöht ist.

Nach einem anderen Ausführungsbeispiel ist vorgesehen, daß die Durchbruchspannung (Gesamtspannung= Uv + Ua ) dadurch erfindungsgemäß erhöht ist, daß die Verarmungsdurchbruchspannung Uv bei gleichbleibender Anreicherungsspannung Ua erhöht wird. Dies ist in der Figur 3 dargestellt.

Im Ausführungsbeispiel der Figur 3 sind wiederum der n-Leiter 8 und der p-Leiter 7 in die Kollektorschicht (Bereich 3) eindiffundiert. Der Aufbau entspricht dem Aufbau des Ausführungsbeispiels der Figur 2, so daß hierauf nicht näher eingegangen werden soll. Unterschiedlich zum Ausführungsbeispiel der Figur 2 ist jedoch, daß nunmehr dem dem n-Leiter 8 benachbarten Kollektorgebiet (Bereich 3) die Oxidschicht 17 mit der größeren Dicke d2 und dem dem p-Leiter 7 zugeordneten Kollektorgebiet (Bereich 3) der Bereich der Oxidschicht 17 zugeordnet ist, der die kleinere Dicke d1 aufweist. Damit hat die Verarmungsdurchbruchspannung Uv infolge der größeren Dicke d2 der Oxidschicht 17 einen vergrößerten Wert. Somit ist die maximal erreichbare Durchbruchspannung Uv + Ua bei gleicher Anreicherungsdurchbruchspannung Ua vergrößert.

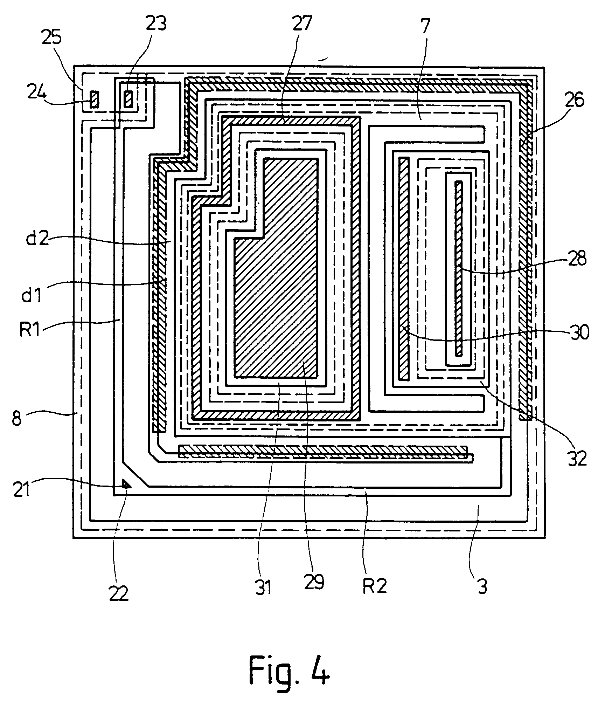

In der Figur 4 wird ein Ausführungsbeispiel einer Layout-Zeichnung eines planaren Darlington-Transistors in Draufsicht gezeigt. In die hochohmige Kollektorschicht (Bereich 3) ist die p-dotierte Basisschicht (p-Leiter 7) eindiffundiert. Die Basismetallisierung 11 befindet sich vollständig innerhalb des p-Leiters 7 (Basisgebiet). Die Widerstände R1 und R2 des Spannungsteilers 12 bilden eine langgestreckte p-leitende Zone. Der Spannungsteiler 12 ist von der Isolationsschicht 10 und der darüber hinweg verlaufenden Elektrodenanordnung D überdeckt. Als Isolationsschicht 10 wird bevorzugt ein thermisches Oxid verwendet. An der Stelle 21 ist -im Bereich des Widerstandes- die Isolationsschicht 10 unterhalb der Elektrode 9 (Deckelelektrode) entfernt. Das so gebildete Kontaktloch 22 dient zum Anschluß der Elektrode 9 an den Spannungsteiler 12. Am kollektorseitigen Ende des Spannungsteilers 12 ist ebenfalls ein Kontaktloch 23 vorgesehen. Außerdem ist die als Stopschicht dienende, hoch dotierte Kollektorschicht (n-Leiter 8) an der mit 24 bezeichneten Stelle kontaktiert. Eine Metallisierungsbrücke 25 stellt eine elektrische Verbindung von dem n-Leiter 8 zum entsprechenden Ende des Spannungsteilers 12 her. Das basisseitige Ende des Spannungsteilers 12 mündet direkt in die p dotierte Basiszone (p-Leiter 7) der Endstufe des dargestellten Darlington-Transistors. Eine mit 26 bezeichnete, schraffierte Fläche stellt den Bereich der Oxidschicht 17 dar, die die geringere Dicke d1 aufweist. Alle übrigen Bereiche unterhalb der Elektrode 9 (Deckelelektrode) sind mit der dickeren Oxidschicht 17 (Dicke d2) versehen.

Ferner erkennt man aus Figur 4 Kontaktierungsflächen für die Endstufenbasis, die mit 27 bezeichnet ist. Ferner sind Kontaktierungsflächen 28,29,30 für die Treiberbasis, für den Endstufenemitter und für den Treiberemitter des Darlington-Transistors vorgesehen. Der Endstufenemitter selbst ist mit 31 und der Treiberemitter mit 32 bezeichnet. Der Übersichtlichkeit halber sind nicht alle Details des Darlington-Transistors, wie zum Beispiel ein Ableitwiderstand des Endstufentransistors, eine Inversdiode usw. eingezeichnet.

Vorzugsweise ist es möglich, daß die Spannungsteilerwiderstände durch einen oder mehrere gesonderte p-Dotierschritte eingebracht werden können. Dadurch lassen sich hohe Widerstandswerte und/oder auch verschiedene Temperaturgradienten erzielen. Vorzugsweise können die Spannungsteilerwiderstände auch abgleichbar ausgebildet sein.

Die vergrößerte Dicke (Dicke d2) der Oxidschicht 17 kann durch zusätzliches Aufbringen einer Passivierungsschicht aus einem thermischen Oxid CVD-Oxid oder Polyimid gebildet werden. Der Bereich 3 (niedrig dotiertes n⁻-Kollektorgebiet) kann zur Bildung der Oxidschicht 17 auch mit einem CVD-Oxid belegt werden.

Die Erfindung ist selbstverständlich nicht auf die Ausbildung eines npn-Transistors begrenzt, sondern eignet sich genauso für pnp-Transistoren oder andere Arten von Halbleitern, die mit p-n-Übergängen versehen sind.

## Patentansprüche

1. Halbleiteranordnung mit einem Substrat in dem ein p-Leiter (7) und ein n-Leiter (8) in einem Abstand an einer Oberfläche des Substrats (3) eingebracht sind und mit einem pn-Übergang, dem im Bereich der zugehörigen Raumladungszone eine Elektrodenanordnung zur Beeinflussung der Durchbruchspannung zugeordnet ist, wobei die Elektrodenanordnung eine Elektrode (9) und eine Isolationsschicht (10) zwischen dem Substrat und der Elektrode aufweist, und wobei an der Elektrode (9) ein Potential zwischen dem Potential des p-Leiters (7) und dem Potential des n-Leiters (8) anlegbar ist, **dadurch gekennzeichnet**, daß die Isolationsschicht (10) in ihrem dem p-Leiter (7) der Raumladungszone des p-n-Übergangs (6) zugeordneten Bereich (19) eine andere Dicke (d1, d2) als in ihrem dem zugehörigen n-Leiter (8) zugeordneten Bereich (20) aufweist.

2. Halbleiteranordnung nach Anspruch 1, **dadurch gekennzeichnet,** daß die Isolationsschicht (10) von einer Oxidschicht (17) gebildet ist.

3. Halbleiteranordnung nach einem der vorhergehenden Ansprüche, **dadurch gekennzeichnet,** daß die Elektrode (9) von einer Metallschicht gebildet ist.

4. Halbleiteranordnung nach einem der vorhergehenden Ansprüche, **dadurch gekennzeichnet,** daß der p-n-Übergang (6) einem Transistor (2), insbesondere einem Transistor einer Darlington-Schaltung, zugeordnet ist.

5. Halbleiteranordnung nach einem der vorhergehenden Ansprüche, **dadurch gekennzeichnet**, daß dem p-n-Übergang (6) ein an eine Gesamtspannung (U) angeschlossener Spannungsteiler (12) mit einem ersten Widerstand (R1) und einem zweiten Widerstand (R2) zugeordnet ist, wobei an dem ersten Widerstand (R1) eine erste Spannung (U1) und an dem zweiten Widerstand (R2) eine zweite Spannung (U2) abfällt, der Mittelanschluß (13) des Spannungsteilers (12) an der Elektrode (9) angeschlossen ist und die beiden übrigen Anschlüsse (14,15) des Spannungsteilers (12) mit den Leitern des p-n-Übergangs (6) in Verbindung stehen, indem der eine Anschluß (14) mit dem p-Leiter (7) und der andere Anschluß (15) mit dem n-Leiter (8) verbunden ist und daß dem einen Widerstand (R1) eine Verarmungsdurchbruchspannung (Uv) und dem anderen Widerstand (R2) eine Anreicherungsdurchbruchspannung (Ua) zugeordnet ist.

6. Halbleiteranordnung nach einem der vorhergehenden Ansprüche, **dadurch gekennzeichnet**, daß die Dicken (d1,d2) der Isolationsschicht (16) derart gewählt sind, daß die Anreicherungsdurchbruchspannung (Ua) bei unveränderter erster Spannung (Uv) beziehungsweise die Verarmungsdurchbruchspannung (Uv) bei unveränderter zweiter Spannung (Ua) im Vergleich zu einer gleichmäßig dicken Isolationsschicht(10) erhöht wird.

## Claims

1. Semiconductor arrangement having a substrate in which a p-type conductor (7) and an n-type conductor (8) are incorporated at a distance on a surface of the substrate (3), and having a pn junction to which an electrode arrangement for influencing the breakdown voltage is assigned in the region of the associated space charge zone, the electrode arrangement having an electrode (9) and an insulation layer (10) between the substrate and the electrode, and it being possible to apply to the electrode (9) a potential between the potential of the p-type conductor (7) and the potential of the n-type conductor (8), characterized in that, in its region (19) assigned to the p-type conductor (7) of the space charge zone of the pn junction (6), the insulation layer (10) has a different thickness (d1, d2) from in its region (20) assigned to the associated n-type conductor (8).

2. Semiconductor arrangement according to Claim 1, characterized in that the insulation layer (10) is formed by an oxide layer (17).

3. Semiconductor arrangement according to one of the preceding claims, characterized in that the electrode (9) is formed by a metal layer.

4. Semiconductor arrangement according to one of the preceding claims, characterized in that the pn junction (6) is assigned to a transistor (2), in particular a transistor of a Darlington circuit.

5. Semiconductor arrangement according to one of the preceding claims, characterized in that a voltage divider (12) connected to a total voltage (U) and having a first resistor (R1) and a second resistor (R2) is assigned to the pn junction (6), there being a first voltage drop (U1) across the first resistor (R1) and a second voltage drop (U2) across the second resistor (R2), the centre connection (13) of the voltage divider (12) being connected to the electrode (9), and the two remaining connections (14, 15) of the voltage divider (12) being connected to the conductors of the pn junction (6), by connecting one connection (14) to the p-type conductor (7) and the other connection (15) to the n-type conductor (8), and in that a depletion-mode breakdown voltage (Uv) is assigned to one resistor (R1) and an enhancement-mode breakdown voltage (Ua) is assigned to the other resistor (R2).

6. Semiconductor arrangement according to one of the preceding claims, characterized in that the thicknesses (dl, d2) of the insulation layer (16) are selected such that, given an unchanged first voltage (Uv), the enhancement-mode breakdown voltage (Ua) or, given an unchanged second voltage (Ua), the depletion-mode breakdown voltage (Uv) is increased compared with a uniformly thick insulation layer (10).

## Revendications

1. Dispositif semi-conducteur avec un substrat dans lequel sont logés un conducteur p (7) et un conducteur n (8) à une certaine distance d'une face du substrat (3), et avec une transition p-n à laquelle est associé, dans la région de la zone correspondante de charge d'espace, un agencement d'électrode qui sert à influencer la tension de claquage, l'agencement d'électrode présentant une électrode (9) et une couche d'isolation (10) entre le substrat et l'électrode, et un potentiel pouvant être appliqué sur l'électrode (9) entre le potentiel du conducteur p (7) et le potentiel du conducteur n (8),
caractérisé en ce que
la couche d'isolation (10) présente dans sa région (19) correspondant au conducteur p (7) de la zone de charge d'espace de la transition p-n (6), une autre épaisseur (d1, d2) que dans sa région (20) correspondant au conducteur n (8).

2. Dispositif semi-conducteur selon la revendication 1,
caractérisé en ce que
la couche d'isolation (10) est formée par une couche d'oxyde (17).

3. Dispositif semi-conducteur selon l'une des revendications précédentes,
caractérisé en ce que
l'électrode (9) est formée par une couche métallique

4. Dispositif semi-conducteur, selon l'une des revendications précédentes,
caractérisé en ce que
la transition p-n est associée à un transistor (2), en particulier à un transistor d'un circuit de Darlington.

5. Dispositif semi-conducteur, selon l'une des revendications précédentes,
caractérisé en ce que
l'on associe à la transition p-n (6) un diviseur de tension (12) raccordé à une tension globale (U), avec une première résistance (R1) et une deuxième résistance (R2), une première tension (U1) chute sur la première résistance (R1) et une deuxième tension (U2) chute sur la deuxième résistance (R2), le branchement central (13) du diviseur de tension (12) étant raccordé à l'électrode (9) et les deux autres branchements (14, 15) du diviseur de tension (12) étant en liaison avec les conducteurs de la transition p-n (6), alors que l'un des branchements, le branchement (14) est relié au conducteur p (7), et l'autre branchement, le branchement (15), est relié au conducteur n (8), et en ce que l'on associe à l'une des résistances, la résistance (R1), une tension de claquage de déplétion (Uv) et à l'autre résistance, (R2), une tension de claquage d'enrichissement (Ua).

6. Dispositif semi-conducteur, selon l'une des revendications précédentes,
caractérisé en ce que
les épaisseurs (d1, d2) de la couche d'isolation (16) sont choisies de telle façon que la tension de claquage d'enrichissement (Ua) est augmentée dans le cas où la première tension (Uv) n'est pas modifiée, et la tension de claquage de déplétion (Uv) est augmentée dans le cas où la deuxième tension (Ua) n'est pas modifiée, par comparaison avec une couche d'isolation (10) d'épaisseur régulière.
